# EUROPEAN PATENT SPECIFICATION

(11) **EP 4 507 012 B1**
(45) Date of publication and mention of the grant of the patent: **29.04.2026**
(21) Application number: 24181993.7
(22) Date of filing: 13.06.2024
(51) Int. Cl.: H10F 10/165, H10F 77/20, H10F 77/30

(54) **SOLAR CELL AND METHOD FOR MANUFACTURING THEREOF, CELL ASSEMBLY, AND PHOTOVOLTAIC SYSTEM**
SOLARZELLE UND VERFAHREN ZUR HERSTELLUNG DAVON, ZELLENANORDNUNG UND FOTOVOLTAISCHES SYSTEM
CELLULE SOLAIRE ET SON PROCÉDÉ DE FABRICATION, ENSEMBLE DE CELLULES ET SYSTÈME PHOTOVOLTAÏQUE

(30) Priority: 08.08.2023 CN 202322129692 U; 08.08.2023 CN 202310996449; 08.03.2024 CN 202410270979
(43) Date of publication of application: 12.02.2025
(73) Proprietor: Zhejiang Aiko Solar Energy Technology Co., Ltd., Yiwu, Jinhua Zhejiang 322000 (CN); Guangdong Aiko Solar Energy Technology Co., Ltd., Foshan, Guangdong 528000 (CN); Tianjin Aiko Solar Energy Technology Co., Ltd., Tianjin 300400 (CN); Zhuhai Fushan Aiko Solar Energy Technology Co., Ltd., FushanIndustrial Park, Doumen District Zhuhai Guangdong 519000 (CN)
(72) Inventor: WANG, Yongqian, YIWU CITY, 322000 (CN); CHEN, Gang, YIWU CITY, 322000 (CN)
(74) Representative: Novagraaf Group

(56) References cited:
- CN-A- 111 063 761
- DE-U1- 202023 101 739
- US-B2- 11 444 212

## Description

### Technical Field

The disclosure relates to the technical field of solar cells, and in particular to a solar cell and a method for manufacturing thereof, a cell assembly, and a photovoltaic system.

### Background

Solar cells can convert sunlight into power based on a photovoltaic effect of p-n junctions of semiconductors, so as to offer sustainable clean energy.

In the related art, a solar cell capable of receiving light on both sides is generally formed by forming a front-surface emitter region and a rear-surface emitter region on an entire front surface and an entire rear surface of a silicon wafer respectively, and then arranging passivation film layers and electrodes. However, in such a solution, the front surface and the rear surface are completely covered with doped layers forming emitters or back surface field regions. Since the doped layers have high parasitic absorption of light rays, a conversion efficiency of the solar cell is low.

A local contact solution can be employed to solve the high parasitic absorption. However, local passivated contact in the prior art has not balanced the relation between parasitic absorption and areas of PN junctions yet. In consequence, although the parasitic absorption is effectively reduced, efficiency is likely to be affected by too small areas of the PN junctions. Especially in the technical solution employing a P-type silicon substrate, a passivation effect of a P-type polysilicon layer on the P-type silicon substrate is undesirable. If P-type doped layers are arranged on an entire front surface and N-type doped layers are arranged on an entire rear surface, parasitic absorption will be high and a passivation effect will be undesirable. If P-type polysilicon is arranged on an entire rear surface and N-type doped layers are arranged on a front surface, the P-type polysilicon will be large-sized, which leads to an undesirable passivation effect on a cell and low efficiency. Also, the N-type doped layers arranged on the front surface have high parasitic absorption of light rays, which also leads to the reduction of conversion efficiency. Moreover, if N-type doped layers on a front surface and P-type doped layers on a rear surface are in local contact, efficiency is likely to be reduced by too small areas of PN junctions.

Therefore, those skilled in the art are attempting to reduce parasitic absorption and ensure efficiency of a solar cell simultaneously.

In addition, a patent document with publication number DE 20 2023 101 739 U1 discloses: The substrate 100 is configured to receive the incident light and generate photogenerated carriers. In some embodiments, the substrate 100 is a silicon substrate, and a material of the silicon substrate includes at least one of monocrystalline silicon, polycrystalline silicon, amorphous silicon, or microcrystalline silicon. In some embodiments, the material of the substrate 100 may also be silicon carbide, an organic material, or a multi-component compound. The multi-component compound includes, without limitation, perovskite, gallium arsenide, cadmium telluride, copper indium diselenide, and other materials. The front and back surfaces of the substrate 100 can be configured to receive incident or reflected light. The first tunneling layer 110 and the first doped conductive layer 120 disposed on the front surface of the substrate 100 are configured to form a passivation contact structure on the front surface of the substrate 100, and the second tunneling layer 140 and the second doped conductive layer 150 on the back surface of the substrate 100 are configured to form a passivation contact structure on the back surface of the substrate 100 . The passivation contact structures are provided on the front surface and the back surface of the substrate 100 such that the solar cell is formed as a double-sided oxide-passivated tunnel contact (TOPCON) cell. Thus, the passivation contact structures formed on the front surface and the back surface of the substrate 100 can play a role in reducing carrier recombination on both the front surface and the back surface of the substrate 100 . Compared to forming a passivation contact structure on only one surface of the substrate 100, the carrier loss of the solar cell is significantly reduced, whereby the Open-circuit voltage and the short-circuit current of the solar cell can be improved.A patent document with publication number US 11 444 212 B2 discloses: A crystalline silicon solar cell includes a gallium oxide layer in direct contact with a P-type silicon layer in the crystalline silicon solar cell. The gallium oxide layer is arranged on the P-type silicon layer of the crystalline silicon solar cell, negative charges of the gallium oxide layer are used to carry out chemical passivation and field passivation on a surface of the P-type silicon layer, and the number of dangling bonds and minority carriers of silicon atoms on the surface of the P-type silicon layer is reduced, so that a minority carrier recombination rate at the surface of the P-type silicon layer is reduced. In addition, the gallium oxide layer has a relatively wide band gap and an appropriate optical refractive index.

### Summary

Aiming at reducing parasitic absorption and ensuring efficiency of a solar cell simultaneously, the disclosure provides a solar cell and a method for manufacturing thereof, a cell assembly, and a photovoltaic system.

The disclosure is implemented as follows: the solar cell in an example of the disclosure includes: a P-type silicon substrate, where the P-type silicon substrate is provided with a first surface and a second surface opposite the first surface, the first surface is a light-facing surface, the second surface is a light-sheltered surface, the first surface is provided with several first regions and several second regions, the first regions and the second regions are alternately arranged in sequence, and the second surface is provided with several third regions and several fourth regions, the third regions and fourth regions are alternately arranged in sequence; P-type doped layers, wherein the P-type doped layers cover the first regions only and do not cover the second regions; first dielectric layers, where the first dielectric layers are arranged between the P-type doped layers and the first surface; N-type doped layers, wherein the N-type doped layerrs cover the third regions only and do not cover the fourth regions, and a total area of all the third regions is greater than a total area of all the first regions; second dielectric layers, where the second dielectric layers are arranged between the N-type doped layers and the second surface; and first electrodes and second electrodes, where the first electrodes are in contact with the P-type doped layers, and the second electrodes are in contact with the N-type doped layers; a first passivation film layer, wherein the first passivation film layer covers the P-type doped layers and the second regions; a second passivation film layer, wherein the second passivation film layer covers the N-type doped layers and the fourth regions.

In some embodiments, areas of at least some of the third regions are greater than those of at least some of the first regions.

In some embodiments, an area of each third region is greater than an area of each first region.

In some embodiments, the number of the first regions is smaller than or equal to the number of the third regions.

In some embodiments, the number of the first electrodes is smaller than or equal to the number of the second electrodes.

In some embodiments, a ratio of a total area of areas of the first regions to an area of the first surface is smaller than 8%.

In some embodiments, the ratio of a total area of the first regions to the area of the first surface is smaller than 6%.

In some embodiments, the ratio of a total area of the first regions to the area of the first surface is smaller than 5%.

In some embodiments, a ratio of a total area of the third regions to an area of the second surface is greater than or equal to 30% and smaller than 100%.

In some embodiments, the ratio of a total area of the third regions to the area of the second surface is greater than or equal to 40% and smaller than 100%.

In some embodiments, the ratio of a total area of the third regions to the area of the second surface is greater than or equal to 50% and smaller than 100%.

In some embodiments, the ratio of a total area of the third regions to the area of the second surface is greater than or equal to 60% and smaller than 100%.

In some embodiments, an oxygen content in the P-type silicon substrate is smaller than or equal to 12.5 ppma.

In some embodiments, the oxygen content in the P-type silicon substrate is smaller than or equal to 12 ppma.

In some embodiments, the oxygen content in the P-type silicon substrate is smaller than or equal to 11 ppma.

In some embodiments, the oxygen content in the P-type silicon substrate is smaller than or equal to 10 ppma.

In some embodiments, portions, corresponding to the first regions, of a surface of the P-type silicon substrate are provided with non-textured structures; and/or portions, corresponding to the first regions, of the surface of the P-type silicon substrate are provided with pyramid base structures or micro-flock structures.

In some embodiments, portions, corresponding to the second regions, of a surface of the P-type silicon substrate are provided with pyramid flocked structures, inverted-pyramid flocked structures, or chain pyramid flocked structures.

In some embodiments, portions, corresponding to the third regions, of a surface of the P-type silicon substrate are provided with non-textured structures; or portions, corresponding to the third regions, of the surface of the P-type silicon substrate are provided with pyramid base structures or micro-flock structures.

In some embodiments, portions, corresponding to the fourth regions, of a surface of the P-type silicon substrate are provided with non-textured structures; or portions, corresponding to the fourth regions, of the surface of the P-type silicon substrate are provided with pyramid base structures or micro-flock structures; or portions, corresponding to the fourth regions, of the surface of the P-type silicon substrate are provided with pyramid structures, inverted-pyramid structures, or chain pyramid flocked structures.

In some embodiments, a thickness of at least one of the N-type doped layers is smaller than a thickness of at least one of the P-type doped layers.

In some embodiments, the P-type doped layers and the N-type doped layers include doped semi-insulating polysilicon layers.

In some embodiments, a width of at least one of the third regions is greater than a width of at least one of the first regions.

In some embodiments, a thickness of at least one of the first dielectric layers is greater than a thickness of a total area of the second dielectric layers.

In some embodiments, the first dielectric layers and the second dielectric layers are porous dielectric layers, and a size of at least one pore in the first dielectric layers is greater than a size of at least one pore in the second dielectric layers.

In some embodiments, the first dielectric layers and the second dielectric layers are porous dielectric layers, and the number of pores per unit area in the first dielectric layers is greater than the number of pores per unit area in the second dielectric layers.

In some embodiments, the second regions and the fourth regions are trench regions.

In some embodiments, trenches corresponding to the second regions extend to portions below the P-type doped layers, and the P-type doped layers include suspended portions suspended above the trenches.

In some embodiments, for at least one of the N-type doped layers, a width of a surface of the N-type doped layer being in contact with the second dielectric layer is greater than, a width of a surface of the N-type doped layer provided with the second electrode.

In some embodiments, first inward-extension layers are formed between the first dielectric layers and the P-type silicon substrate, and the first preset distances are provided between first inward-extension layers positioned at edges of the P-type silicon substrate and side surfaces of the P-type silicon substrate.

In some embodiments, second inward-extension layers are formed between the second dielectric layers and the P-type silicon substrate, and second preset distances are provided between second inward-extension layers positioned at the edges of the P-type silicon substrate and the side surfaces of the P-type silicon substrate.

In some embodiments, a thickness of at least one of the second inward-extension layers is greater than a thickness of at least one of the first inward-extension layers; and/or a doping concentration of at least one of the second inward-extension layers is greater than a doping concentration of at least one of the first inward-extension layers; and/or a width of at least one of the second inward-extension layers is greater than a width of at least one of the first inward-extension layers.

In some embodiments, the second preset distances are greater than the first preset distances.

In some embodiments, distances between N-type doped layers positioned at edges of the P-type silicon substrate and side surfaces of the P-type silicon substrate are greater than those between P-type doped layers positioned at the edges of the P-type silicon substrate and the side surfaces of the P-type silicon substrate.

The disclosure further provides a method for manufacturing for a solar cell. The method includes: a P-type silicon substrate is provided, where the P-type silicon substrate is provided with a first surface and a second surface opposite the first surface, the first surface is a light-facing surface, the second surface is a light-sheltered surface, the first surface is provided with several first regions and several second regions that are alternately arranged in sequence, the second surface is provided with several third regions and several fourth regions that are alternately arranged in sequence, and a total area of all the third regions is greater than that of all the first regions; first dielectric layers and P-type doped layers are formed on the first regions in sequence, wherein the P-type doped layers do not cover the second regions; second dielectric layers and N-type doped layers are formed on the third regions in sequence, wherein the N-type doped layers do not cover the fourth regions; a first passivation film layer and a second passivation film layer are manufactured on the first surface and the second surface respectively, wherein the first passivation film layer covers the P-type doped layers and the second regions and the second passivation film layer covers the N-type doped layers and the fourth regions; and first electrodes and second electrodes are manufactured on the first passivation film layer and the second passivation film layer respectively, where the first electrodes penetrate the first passivation film layer to make contact with the P-type doped layers, and the second electrodes penetrate the second passivation film layer to make contact with the N-type doped layers.

In some embodiments, the step that first dielectric layers and P-type doped layers are formed on the first regions in sequence includes: the first dielectric layers are manufactured on an entire first surface; the P-type doped layers are manufactured on the first dielectric layers; winding plating layers formed in a process of manufacturing the P-type doped layers are removed; and the P-type doped layers and the first dielectric layers are patterned, so as to form several spaced grooves on the P-type doped layers and the first dielectric layers and expose part of the P-type silicon substrate from the grooves, where portions, exposed from the grooves, of the first surface are the second regions, and unexposed portions of the first surface are the first regions.

In some embodiments, the step that second dielectric layers and N-type doped layers are formed on the third regions in sequence includes: the second dielectric layers are manufactured on an entire second surface; the N-type doped layers are manufactured on the second dielectric layers; winding plating layers formed in a process of manufacturing the N-type doped layers are removed; and the N-type doped layers and the second dielectric layers are patterned, so as to form several spaced grooves on the N-type doped layers and the second dielectric layers and expose part of the P-type silicon substrate from the grooves, where portions, exposed from the grooves, of the second surface are the fourth regions, and unexposed portions of the second surface are the third regions.

The disclosure further provides a cell assembly. The cell assembly includes any solar cell described above.

The disclosure further provides a photovoltaic system. The photovoltaic system includes the cell assembly described above.

Some additional aspects and advantages of the disclosure will be set forth in the following description, and other additional aspects and advantages will be apparent from the following description or learned by practice of the disclosure.

### Brief Description of the Drawings

Fig. 1 is a schematic modular diagram of a photovoltaic system according to an example of the disclosure;
Fig. 2 is a schematic modular diagram of a cell assembly according to an example of the disclosure;
Fig. 3 is a schematic structural diagram of a section of a solar cell according to an example of the disclosure;
Fig. 4 is a schematic structural diagram of a part of a solar cell according to an example of the disclosure;
Fig. 5 is another schematic structural diagram of a part of a solar cell according to an example of the disclosure;
Fig. 6 is another schematic structural diagram of a section of a solar cell according to an example of the disclosure;
Fig. 7 is yet another schematic structural diagram of a section of a solar cell according to an example of the disclosure;
Fig. 8 is a schematic flowchart of a method for manufacturing for a solar cell according to an example of the disclosure;
Fig. 9 is another schematic flowchart of a method for manufacturing for a solar cell according to an example of the disclosure; and
Fig. 10 is yet another schematic flowchart of a method for manufacturing for a solar cell according to an example of the disclosure.

Main reference numerals include:
Photovoltaic system 1000, cell assembly 200, solar cell 100, P-type silicon substrate 10, first surface 11, first region 111, second region 112, second surface 12, third region 121, fourth region 122, P-type doped layer 20, first dielectric layer 30, N-type doped layer 40, second dielectric layer 50, first electrode 60, second electrode 70, first passivation film layer 80, second passivation film layer 90, first inward-extension layer 110, and second inward-extension layer 120.

### Detailed Description of the Embodiments

In order to make the objectives, technical solutions, and advantages of the disclosure clearer, the disclosure will be further described in detail below with reference to the accompanying drawings and examples. The examples are illustratively shown in the accompanying drawings. The same or similar reference numerals denote the same or similar elements or elements having the same or similar functions throughout. The examples described below with reference to the accompanying drawings are illustrative and are intended to explain the disclosure, but cannot be interpreted as limiting the disclosure. In addition, it should be understood that the specific examples described herein are merely used to explain the disclosure and are not intended to limit the disclosure.

In the description of the disclosure, it should be understood that the orientation or position relations indicated by the terms "up", "down", "length", "width", "rear surface", etc. are based on the orientation or position relations shown in the accompanying drawings, are merely for facilitating the description of the disclosure and simplifying the description, rather than indicating or implying that the device or element referred to must have a particular orientation or be constructed and operated in a particular orientation, and therefore cannot be interpreted as limiting the disclosure.

In the disclosure, a first feature is "on" or "underneath" a second feature can indicate that the first feature and the second feature are in direct contact, or in indirect contact through another feature therebetween unless explicitly specified and limited otherwise. Moreover, the first feature is "on", "above", and "over" the second feature includes that the first feature is exactly above the second feature or not, or merely indicates that the first feature has a higher level than the second feature. The first feature is "underneath", "below", and "under" the second feature includes that the first feature is exactly below the second feature or not, or merely indicates that the first feature has a lower level than the second feature.

The following disclosure provides various different examples or instances configured to implement different structures of the disclosure. Components and configurations in specific instances are described below, in order to simplify the contents of the disclosure. Certainly, the components and configurations are merely illustrative and are not intended to limit the disclosure. In addition, the disclosure can repeat the reference numerals and/or reference letters in different instances. Such repetition is configured for simplicity and clarity and does not indicate a relation between various examples and/or configurations discussed in itself. In addition, the disclosure provides instances of various specific processes and materials, but those of ordinary skill in the art can recognize applications of other processes and/or use scenarios of other materials.

### Example 1

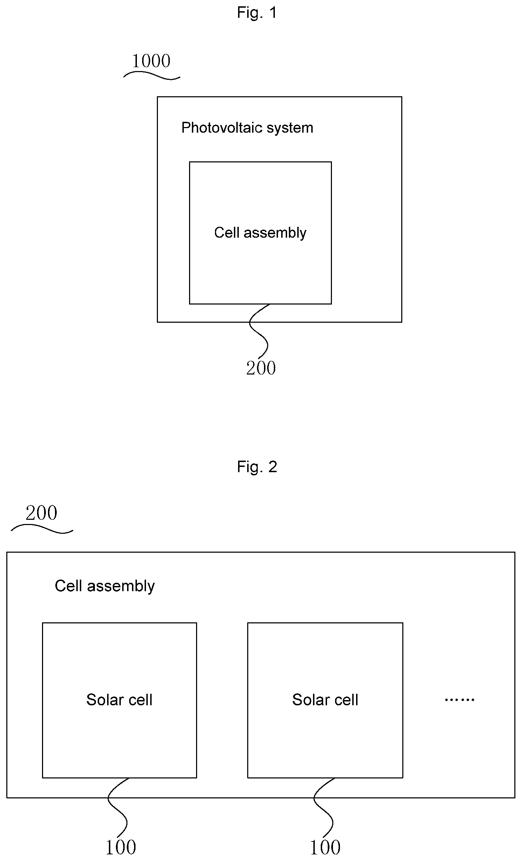

With reference to Figs. 1-2, a photovoltaic system 1000 in an example of the disclosure may include a cell assembly 200 in an example of the disclosure. The cell assembly 200 in the example of the disclosure may include a plurality of solar cells 100 in an example of the disclosure. The plurality of solar cells 100 in the cell assembly 200 may be sequentially connected in series to form cell strings. All the cell strings may be connected in series, in parallel, or in series-parallel to realize a bus output of currents. For example, all the cells may be connected by welding a solder ribbon, and all the cell strings may be connected through bus bars.

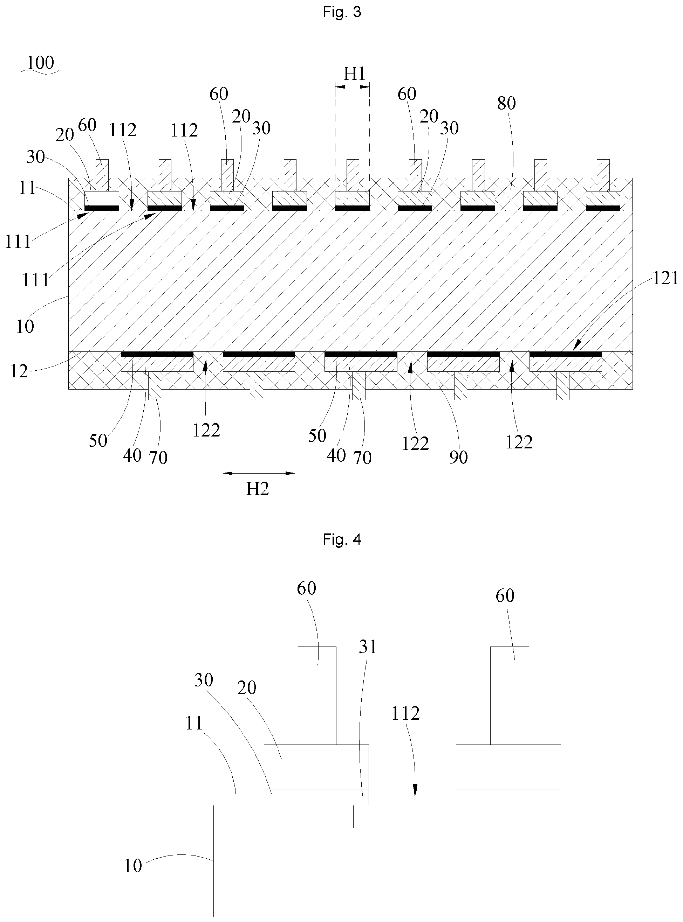

With reference to Fig. 3, the solar cell 100 in the example of the disclosure may include a P-type silicon substrate 10, P-type doped layers 20, first dielectric layers 30, N-type doped layers 40, second dielectric layers 50, first electrodes 60, and second electrodes 70.

As shown in Fig. 3, the P-type silicon substrate 10 is provided with a first surface 11 and a second surface 12 opposite the first surface 11, where the first surface 11 is a light-facing surface, and the second surface 12 is a light-sheltered surface. The light-facing surface may be interpreted as a surface facing sunlight when the solar cell 100 is mounted, and the light-sheltered surface may be interpreted as a surface sheltered from sunlight when the solar cell 100 is mounted. The first surface 11 is provided with several first regions 111 and several second regions 112 that are alternately arranged in sequence, and the second surface 12 is provided with several third regions 121 and several fourth regions 122 that are alternately arranged in sequence.

The P-type doped layers 20 are arranged on the first regions 111 and do not cover the second regions 112. In other words, several P-type doped layers 20 are arranged at intervals through the second regions 112 on the first surface 11, and two adjacent P-type doped layers 20 are spaced from each other through one second region 112. The first dielectric layers 30 are arranged between the P-type doped layers 20 and the first surface 11.

Specifically, the first dielectric layers 30 may be tunneling oxide layers, such as silicon dioxide film layers. The first dielectric layers 30 may cover entire first regions 111 or entire first regions 111 and at least some of the second regions 112.

The N-type doped layers 40 are arranged on the third regions 121 and do not cover the fourth regions 122. The second dielectric layers 50 are arranged between the N-type doped layers 40 and the second surface 12. The polarity of the N-type doped layers 40 is opposite to the polarity of the P-type doped layers 20. In other words, several N-type doped layers 40 are arranged at intervals through the fourth regions 122 on the second surface 12, and two adjacent N-type doped layers 40 are spaced from each other through one fourth region 122. A total area of all the third regions 121 is greater than that of all the first regions 111. Understandably, in the P-type silicon substrate 10, a total area of the first surface 11 equals a total area of the second surface 12. Moreover, the total area of all the third regions 121 is greater than that of all the first regions 111, which means that in the solar cell 100, a total area of all the N-type doped layers 40 is greater than that of all the P-type doped layers 20.

Specifically, the second dielectric layers 50 may also be tunneling oxide layers, such as silicon dioxide film layers. The second dielectric layers 50 may cover entire third regions 121 to realize tunneling of carriers. Alternatively, the second dielectric layers 50 may cover entire third regions 121 and at least some of the fourth regions 122, which will not be limited herein.

The first electrodes 60 are in contact with the P-type doped layers 20, and the second electrodes 70 are in contact with the N-type doped layers 40.

According to the solar cell 100, the cell assembly 200, and the photovoltaic system 1000 in the examples of the disclosure, the P-type silicon substrate 10 is used as a base layer of the solar cell 100. The P-type doped layers 20 cover the first regions 111 of the first surface 11 only, instead of the second regions 112. The N-type doped layers 40 cover the third regions 121 of the second surface 12 only, instead of the fourth regions 122. The total area of all the third regions 121 is greater than that of all the first regions 111.

Therefore, the P-type silicon substrate 10 is used as the base layer, the first surface 11 of the P-type silicon substrate 10 is not completely covered with the P-type doped layers 20, and the second surface 12 of the P-type silicon substrate is not completely covered with the N-type doped layers 40. In other words, the P-type doped layers are arranged only on the first region 111 for local passivation, and a first passivation film layer 80 is employed on the second regions 112 for direct passivation. Accordingly, passivation performance is desirable, and a passivation effect on the first surface 11 can be improved. In this way, the passivation effect can be improved while parasitic absorption of light rays by the P-type doped layers 20 and the N-type doped layers 40 can be effectively reduced, so that conversion efficiency can be improved. Moreover, on the P-type silicon substrate 10, the P-type doped layers 20 are locally arranged on the light-facing surface, so that the passivation effect can be improved while the parasitic absorption can be reduced. In addition, the N-type doped layers 40 are locally arranged on the light-sheltered surface, and the total area of all the third regions 121 is set to be greater than that of all the first regions 111, so that the reduction of efficiency caused by too small areas of PN junctions can be avoided while parasitic absorption on a rear surface can be reduced.

Understandably, since the P-type doped layers 20 have an undesirable passivation effect on the P-type silicon substrate 10 and have parasitic absorption, it is required to reduce areas of the P-type doped layers 20 as much as possible, so as to reduce the parasitic absorption and improve the passivation effect. Moreover, parasitic absorption on the light-facing surface of the solar cell 100 has a greater impact on efficiency than parasitic absorption on the light-sheltered surface. Therefore, the P-type doped layers 20 are locally arranged on the light-facing surface, so that the passivation effect can be improved while the parasitic absorption can be reduced. Moreover, the areas of the PN junctions also affect the effect of the solar cell 100. If the N-type doped layers 40 are arranged on the light-facing surface and the P-type doped layers 20 are arranged on the light-sheltered surface, areas of the N-type doped layers 40 are required to be set to be smaller in order to reduce the parasitic absorption on the light-facing surface as much as possible. Moreover, areas of the P-type doped layers 20 are also required to be set to be smaller to improve the passivation effect. However, under such a condition, the efficiency is affected by small areas of the PN junctions of the solar cell 100, which is contradictory.

Therefore, in the example of the disclosure, the P-type silicon substrate 10 is used, the P-type doped layers 20 are locally arranged on the light-facing surface, and the N-type doped layers 40 are arranged on the light-sheltered surface. Moreover, the total area of all the third regions 121 is set to be greater than that of all the first regions 111. Therefore, the passivation effect can be improved while the parasitic absorption on the light-facing surface and the light-sheltered surface can be reduced. Moreover, the situation that the efficiency is affected by the too small areas of the PN junctions when the areas of the N-type doped layers 40 are too small can also be avoided.

That is, in the example of the disclosure, the silicon substrate, the P-type doped layers 20, and the N-type doped layers 40 of the solar cell 100 are structurally designed, and the total area of the third regions 121 is set to be greater than that of the first regions 111. Therefore, the passivation effect can be improved and the areas of the PN junctions can be ensured as much as possible while the parasitic absorption on the light-facing surface and the light-sheltered surface can be reduced, so that the efficiency of the solar cell 100 can be improved. In other words, although the P-type doped layers 20 and the N-type doped layers 40 are in local contact with the P-type silicon substrate 10, due to the reduction of the parasitic absorption, the improvement in the passivation effect, and appropriate setting of the areas of the third regions 121 and the areas of the first regions 111, the efficiency of the solar cell 100 can also be improved.

Specifically, in the example of the disclosure, the solar cell 100 is a solar cell of a double-sided passivated contact structure. The first dielectric layers 30 and the P-type doped layers 20 form tunneling passivated structures on the first surface 11, and the second dielectric layers 50 and the N-type doped layers 40 form tunneling passivated structures on the second surface 12.

Understandably, as shown in Fig. 3, the first passivation film layer 80 is further arranged on the first surface 11 of the solar cell 100 of the disclosure. The first passivation film layer 80 covers the entire first surface 11. In other words, the first passivation film layer 80 covers the P-type doped layers 20 and the second regions 112.

A second passivation film layer 90 is arranged on the second surface 12. The second passivation film layer 90 covers the entire second surface 12. In other words, the second passivation film layer 90 covers the N-type doped layers 40 and the fourth regions 122. The first electrodes 60 penetrate the first passivation film layer 80 to be in contact with the P-type doped layers 20. The second electrodes 70 penetrate the second passivation film layer 90 to be in contact with the N-type doped layers 40.

The first passivation film layer 80 may include at least one or a combination of a plurality of an aluminum oxide film layer, a silicon oxide film layer, a silicon nitride film layer, a silicon carbide film layer, and a silicon oxynitride film layer. For example, in some examples, the first passivation film layer 80 may include an aluminum oxide film layer and a silicon nitride film layer stacked in sequence, which will not be limited herein. The second passivation film layer 90 may also include at least one or a combination of a plurality of an aluminum oxide film layer, a silicon oxide film layer, a silicon nitride film layer, a silicon carbide film layer, and a silicon oxynitride film layer.

Understandably, in the example of the disclosure, the cell assembly 200 may further include a metal frame, a back plate, photovoltaic glass, and an adhesive film (none of the above is shown in the figures). The adhesive film may fill gaps between a front surface of the solar cell 100 and the photovoltaic glass, between a rear surface of the solar cell and the back plate, between adjacent cells, etc. The adhesive film, filler, may be a transparent adhesive having desirable light transmission performance and aging resistance. For example, the adhesive film may be a polyethylene vinylacetate (EVA) adhesive film or a polyethylene-1-octene (POE) adhesive film, which may be specifically selected according to an actual situation and will not be limited herein.

The photovoltaic glass may cover the adhesive film on the front surface of the solar cell 100. The photovoltaic glass may be ultra-clear glass having high transmittance, high transparency, and excellent physical, mechanical, and optical properties. For example, the ultra-clear glass may have the transmittance of 92% or higher and protect the solar cell 100 without affecting the efficiency of the solar cell 100 as much as possible. Moreover, the photovoltaic glass may adhere to the solar cell 100 through the adhesive film. The adhesive film may seal, insulate, and waterproof the solar cell 100.

The back plate may adhere to the adhesive film on the rear surface of the solar cell 100 to protect and support the solar cell 100, and has the reliable insulativity, water resistance, and aging resistance. A plurality of materials may be selected as the back plate, generally including tempered glass, organic glass, aluminum alloy-Tedlar+polyethylene terephthalate+Tedlar (TPT) composite adhesive film, etc., which may be specifically configured according to a specific condition and will not be limited herein. An assembly formed by the back plate, the solar cell 100, the adhesive film, and the photovoltaic glass may be arranged on the metal frame. The metal frame serves as a primary external support structure of an entire cell assembly 200, so as to stably support and mount the cell assembly 200. For example, the cell assembly 200 may be mounted at a desired position through the metal frame.

Further, in the example, the photovoltaic system 1000 may be applied to photovoltaic power stations, such as a ground power station, a rooftop power station, and a water surface power station, and may also be applied to apparatuses or devices that generate power through solar energy, such as a solar power source of a user, a solar street lamp, a solar vehicle, and a solar building. Certainly, it can be understood that the application scenarios of the photovoltaic system 1000 are not limited to the above. In other words, the photovoltaic system 1000 may be applied to all fields for power generation through solar energy. With a photovoltaic power generation system network as an example, the photovoltaic system 1000 may include a photovoltaic array, a bus box, and an inverter. The photovoltaic array may be an array combination of a plurality of cell assemblies 200. For example, the plurality of cell assemblies 200 may form a plurality of photovoltaic arrays, and the photovoltaic arrays are connected to the bus box. The bus box may combine currents generated through the photovoltaic arrays. The currents combined flow through the inverter to be converted into alternating currents required by a mains power grid and then are connected to the mains power grid to realize power supply through solar energy.

In some examples, areas of at least some of the third regions 121 are greater than those of at least some of the first regions 111. Therefore, by setting the areas of at least some of the third regions 121 larger, the total area of all the third regions 121 may also be greater than that of all the first regions 111. Accordingly, the areas of the PN junctions are ensured to ensure the efficiency while the parasitic absorption is reduced.

In some examples, preferably, an area of each third region 121 may be greater than that of each first region 111, so that the total area of all the third regions 121 is greater than that of all the first regions 111.

Further, in some examples, the number of the first regions 111 is smaller than or equal to that of the third regions 121.

Moreover, in some examples, the number of the first electrodes 60 is smaller than that of the second electrodes 70. In this way, under the condition that each first electrode 60 corresponds to one P-type doped layer 20, and each second electrode 70 corresponds to one N-type doped layer 40, more N-type doped layers 40 are provided. Therefore, a total area of all the N-type doped layers 40 may be greater than that of all the P-type doped layers 20. Accordingly, the areas of the PN junctions are ensured to ensure the efficiency while the parasitic absorption is reduced.

In some examples, a total area of all the second regions 112 is greater than that of all the fourth regions 122. In this way, by appropriately setting the areas of the second regions 112 and the areas of the fourth regions 122, the total area of all the third regions 121 may be set to be greater than that of all the first regions 111. In other words, by controlling the areas of the second regions 112 to be larger, contact areas between the P-type doped layers 20 and the P-type silicon substrate may be reduced as much as possible. Accordingly, the passivation effect can be improved while the parasitic absorption is reduced. Moreover, the situation that the areas of the PN junctions are reduced to affect the efficiency when the areas of the N-type doped layers 40 are too small can be avoided.

Further, in some examples, preferably, an area of a single second region 112 is greater than that of a single fourth region 122, so that the total area of all the second regions 112 is greater than that of all the fourth regions 122.

In some examples, a thickness of at least one of the N-type doped layers 40 is smaller than a thickness of at least one of the P-type doped layers 20.

Therefore, in the P-type silicon substrate 10, the thickness of at least one of the P-type doped layers 20 is set larger to improve the passivation effect on the first surface 11, so that the electric performance of the cell is improved. In other words, the passivation effect can be improved by increasing the thickness of at least one of the P-type doped layers 20.

In some examples, the P-type doped layers 20 and the N-type doped layers 40 may include doped semi-insulating polysilicon layers. Therefore, the P-type doped layers 20 and the N-type doped layers 40 are made of semi-insulating polysilicon, which has less parasitic absorption than conventional polysilicon. In other words, such a material can reduce the parasitic absorption and improve the conversion efficiency.

### Example 2

In some examples, a ratio of a total area of the first regions 111 to an area of the first surface 11 (i.e., an area ratio of the first regions 111) is smaller than 8%.

Therefore, by setting the ratio of a total area of the first regions 111 to the area the first surface 11 within a range of being smaller than 8%, an area ratio of the P-type doped layers 20 may be greatly reduced. Accordingly, parasitic absorption by the P-type doped layers 20 is reduced, and efficiency is improved. Moreover, by setting the areas of the first regions 111 smaller, the areas of the second regions 112 may be expanded, so that the passivation effect on the first surface 11 is improved. In other words, the passivation effect on the first surface 11 can be improved while the parasitic absorption can be reduced, so that the efficiency can be improved.

Further, in such an example, the ratio of a total area of the first regions 111 to the area of the first surface 11 is preferably smaller than 6%, and more preferably smaller than 5%. In this way, the areas of the first regions 111 may be set as small as possible to improve the passivation effect while the parasitic absorption is reduced.

### Example 3

In some examples, a ratio of a total area of the third regions 121 to an area of the second surface 12 is greater than or equal to 30% and smaller than 100%.

Therefore, by setting the areas of the third regions 121 on the second surface 12 larger, an area ratio of the N-type doped layers 40 can also be ensured under the condition that the parasitic absorption can be reduced, and passivated contact areas (the areas of the PN junctions) of the N-type doped layers 40 and the parasitic absorption can be balanced, so that conversion efficiency can be improved.

Further, in such an example, the ratio of a total area of the third regions 121 to the area of the second surface 12 is preferably greater than or equal to 40% and smaller than 100%. In some embodiments, in such an example, the ratio of a total area of the third regions 121 to the area of the second surface 12 is more preferably greater than or equal to 50% and smaller than 100%, and most preferably greater than or equal to 60% and smaller than 100%. In this way, the parasitic absorption and the areas of the PN junctions can be balanced. Accordingly, the areas of the PN junctions are ensured as much as possible to ensure the efficiency while the parasitic absorption is reduced.

### Example 4

In some examples, an oxygen content in the P-type silicon substrate 10 is smaller than or equal to 12.5 ppma.

Therefore, the oxygen content in the P-type silicon substrate 10 is set to be smaller than 12.5 ppma. Accordingly, the situation that the oxygen content in the P-type silicon substrate 10 is too high, leading to oxygen precipitates in the P-type silicon substrate 10 during formation of the P-type doped layers 20 and the N-type doped layers 40 in a later stage, so that the lifetime of minority carriers in the P-type silicon substrate 10 is shortened can be avoided, and the conversion efficiency can be improved.

Specifically, it is not difficult to understand that in a manufacturing process of the cell, emitters on the front surface and back surface fields (i.e., the P-type doped layers 20 and the N-type doped layers 40) are manufactured by employing a high temperature for treatment generally. If the oxygen content in the P-type silicon substrate 10 is too high in a high temperature process, annular or spiral oxygen precipitates distributed in a radial direction are generated in the P-type silicon substrate 10 in the high temperature process. In consequence, the lifetime of the minority carriers in the P-type silicon substrate is shortened, resulting in high light-induced degradation and low conversion efficiency.

In the disclosure, the inventors of the disclosure have found through studies and verification that by controlling the oxygen content in the P-type silicon substrate 10 within 12.5 ppma, the oxygen precipitates can be effectively suppressed, so that the conversion efficiency can be improved.

Further, in such an example, the oxygen content in the P-type silicon substrate 10 may preferably be smaller than or equal to 12 ppma. In some embodiments, in such an example, the oxygen content in the P-type silicon substrate 10 is more preferably smaller than or equal to 11 ppma, and most preferably smaller than 10 ppma. Specifically, the inventors of the disclosure have found through studies and verification that when the oxygen content is reduced to 12 ppma, 11 ppma, or even 10 ppma or lower, the oxygen precipitates can be further suppressed, and the lifetime of the minority carriers can be further prolonged.

### Example 5

In some examples, portions, corresponding to the first regions 111, of a surface of the P-type silicon substrate 10 may be provided with non-textured structures. In other words, surface regions corresponding to the first regions 111 may be non-textured surfaces.

Certainly, in some examples, the portions, corresponding to the first regions 111, of the surface of the P-type silicon substrate 10 are provided with pyramid base structures or micro-flock structures. In other words, the surface regions corresponding to the first regions 111 are pyramid base planes or micro-flock surfaces.

Understandably, in some examples, the portions, corresponding to the first regions 111, of the surface of the P-type silicon substrate 10 may also be provided with the non-textured structures and the pyramid base structures or the micro-flock structures simultaneously, which will not be limited herein.

### Example 6

In some examples, portions, corresponding to the second regions 112, of a surface of the P-type silicon substrate 10 are provided with pyramid flocked structures, inverted-pyramid flocked structures, or chain pyramid flocked structures.

### Example 7

In some examples, portions, corresponding to the third regions 121, of a surface of the P-type silicon substrate 10 are provided with non-textured structures. In other words, surface regions corresponding to the third regions 121 may be non-textured surfaces.

Certainly, in some examples, the portions, corresponding to the third regions 121, of the surface of the P-type silicon substrate 10 are provided with pyramid base structures or micro-flock structures. In other words, the surface regions corresponding to the third regions 121 are pyramid base surfaces or micro-flock surfaces.

Understandably, in some examples, the portions, corresponding to the third regions 121, of the surface of the P-type silicon substrate 10 may also be provided with the non-textured structures and the pyramid base structures or the micro-flock structures simultaneously, which will not be limited herein.

### Example 8

In some examples, portions, corresponding to the fourth regions 122, of a surface of the P-type silicon substrate 10 are provided with pyramid flocked structures, inverted-pyramid flocked structures, or chain pyramid flocked structures.

### Example 9

With reference to Fig. 3, in some examples, a width H2 of the third regions 121 is greater than a width H1 of the first regions 111.

Therefore, a width of at least one of N-type doped layers 40 on the third regions 121 on the light-sheltered surface is greater than that of at least one of P-type doped layers 20 on the first regions 111 on the light-facing surface. Therefore, the situation that the efficiency is greatly affected by too small passivated contact areas (i.e., the area of the PN junctions) between the N-type doped layers 40 and the P-type silicon substrate 10 can be avoided while the parasitic absorption by the N-type doped layers 40 can be reduced. Understandably, in such an example, a length of the first regions 11 equals a length of the third regions 121.

### Example 10

In some examples, a thickness of at least one of the first dielectric layers 30 is greater than that of at least one of the second dielectric layers 50.

Therefore, the passivation effect on the first surface 11 can be ensured by setting the thickness of at least one of the first dielectric layers 30 larger.

Specifically, in such an example, since the P-type doped layers 20 of the P-type silicon substrate 10 have an undesirable passivation effect, in order to ensure the passivation effect on the light-facing surface, the thickness of at least one of the first dielectric layers 30 may be set larger to improve the efficiency.

### Example 11

In some examples, the first dielectric layers 30 and the second dielectric layers 50 are porous dielectric layers, and a size of at least one of pores in the first dielectric layers 30 is greater than that of at least one of pores in the second dielectric layers 50.

Therefore, the first dielectric layers 30 and the second dielectric layers 50 are configured as the porous dielectric layers, and the pores in the first dielectric layers 30 are greater in size, so that longitudinal resistance of the first dielectric layers 30 may be controlled to an appropriate level.

Further, in some examples, the first dielectric layers 30 and the second dielectric layers 50 are the porous dielectric layers, and the number of pores per unit area in the first dielectric layers 30 is greater than that of pores per unit area in the second dielectric layers 50.

Therefore, the greater the number of the pores per unit area in the first dielectric layers 30 is, the more appropriate the level of the longitudinal resistance of the first dielectric layers 30 is.

### Example 12

In some examples, the second regions 112 and the fourth regions 122 are trench regions. In other words, the P-type silicon substrate 10 is recessed to form grooves at the second regions 112 and the fourth regions 122.

Therefore, portions, covering the second regions 112, of the P-type doped layers 20 and the first dielectric layers 30 and portions, covering the fourth regions 122, of the N-type doped layers 40 and the second dielectric layers 50 may be removed by forming the trench regions. Therefore, the second regions 112 exposed and the fourth regions 122 exposed are formed. Accordingly, the first passivation film layer 80 and the second passivation film layer 90 may directly cover portions, at the second regions 112 and the fourth regions 122, of the P-type silicon substrate 10, so that the passivation performance is improved.

Specifically, in such an example, the first dielectric layers 30 and the P-type doped layers 20 may be formed on the first surface 11. Then, parts of the first dielectric layers 30 and parts of the P-type doped layers 20 may be etched away to form the second regions 112 (i.e., the trench regions). Similarly, for the fourth regions 122, the second dielectric layers 50 and the N-type doped layers 40 may also be formed on the second surface 12. Then, parts of the second dielectric layers 50 and parts of the N-type doped layers 40 are etched away to form the fourth regions 122 (i.e., the trench regions).

### Example 13

Further, with reference to Fig. 4, in some examples, trenches corresponding to second regions 112 extend to portions below the P-type doped layers 20, and the P-type doped layers 20 include suspended portions 31 suspended above the trenches.

Therefore, when the second regions 112 serving as the trench regions are formed, the trenches extend to etch away portions, below the P-type doped layers 20, of the P-type silicon substrate 10, so that the P-type doped layers 20 are provided with the suspended portions 31. Therefore, passivated contact areas between the P-type doped layers 20 and the P-type silicon substrate 10 can be further narrowed, and the passivation effect can be improved.

### Example 14

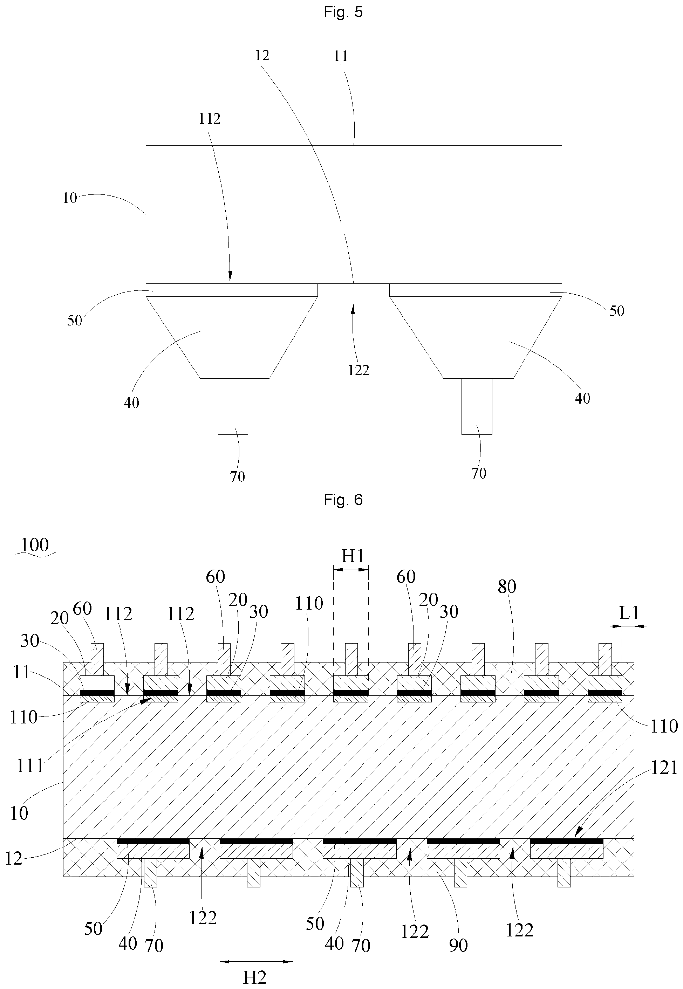

With reference to Fig. 5. in some examples, for at least one of the N-type doped layers, a width of a surface of the N-type doped layer being in contact with the second dielectric layer 50 is greater than, a width of a surface of the N-type doped layer 40 provided with the second electrode 70.

Therefore, the situation that cell efficiency is greatly impacted by too small passivated contact areas between the N-type doped layers 40 and the P-type silicon substrate 10 can be avoided.

Specifically, as shown in Fig. 5, in such an example, the N-type doped layers 40 may be in an inverted trapezoid shape, and the width of at least one of the N-type doped layers 40 is gradually decreased in a direction from the first surface 11 to the second surface 12.

### Example 15

With reference to Fig. 6, in some examples, first inward-extension layers 110 are formed between the first dielectric layers 30 and the P-type silicon substrate 10, and first preset distances L1 are provided between first inward-extension layers 110 positioned at edges of the P-type silicon substrate 10 and side surfaces of the P-type silicon substrate 10. Wherein, the first inward-extension layers 110 is a doped region formed in the P-type silicon substrate 10 on one side close to the first surface 11. The first inward-extension layers 110 may be formed by various doping methods (e.g., thermal diffusion, ion implantation, etc.), and the first inward-extension layers 110 may be doped with a dopant of the same conductivity type as the P-type silicon substrate 10 during the doping process.

Therefore, when the P-type doped layers 20 are formed, the first inward-extension layers 110 are formed on the P-type silicon substrate 10, and the first inward-extension layers 110 at edge positions are configured to be spaced from the side surfaces of the P-type silicon substrate 10 by certain distances. Therefore, power leakage generated when the first inward-extension layers 110 extend to the edges of the P-type silicon substrate 10 to be in contact with the N-type doped layers 40 on the second surface 12 can be avoided.

Specifically, the "first inward-extension layers 110 positioned at edges of the P-type silicon substrate 10 " mean first inward-extension layers 110 positioned at outermost edges of two sides, in an arrangement direction of the first regions 111 and the second regions 112, of the first surface 11 of the P-type silicon substrate 10. As shown in Fig. 6, the first inward-extension layers 110 positioned at the edges of the P-type silicon substrate 10 are a first leftmost inward-extension layer 110 and a first rightmost inward-extension layer 110 in Fig. 6. The side surfaces of the P-type silicon substrate 10 mean a left side surface and a right side surface in Fig. 6.

In such an example, the first preset distance may be 0.3 µm-50 µm. For example, the first preset distance may equal 0.3 µm, 0.4 µm, 0.5 µm, 0.6 µm, 0.7 µm, 0.8 µm, 0.9 µm, 1 µm, 2 µm, 3 µm, 4 µm, 5 µm, 6 µm, 7 µm, 8 µm, 9 µm, 10 µm, 15 µm, 20 µm, 25 µm, 30 µm, 40 µm, 45µm, or 50 µm, or any value between 0.3 µm and 50 µm, which will not be specifically limited herein. In the example of the disclosure, the first preset distance may preferably be 1 µm-20 µm.

### Example 16

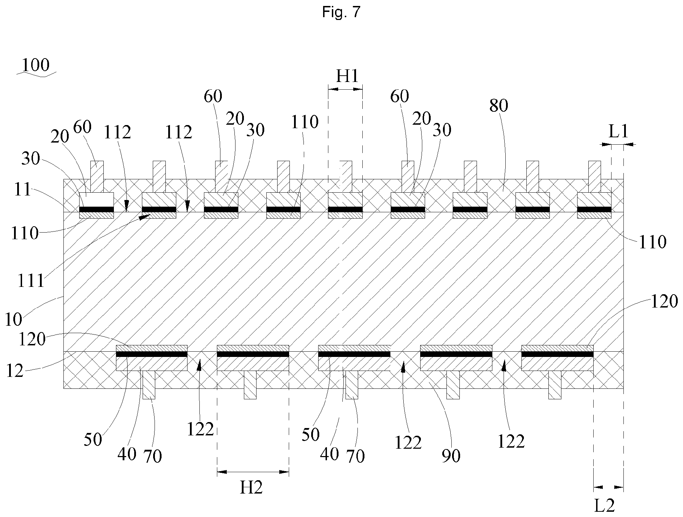

With reference to Fig. 7, in some examples, second inward-extension layers 120 are formed between the second dielectric layers 50 and the P-type silicon substrate 10, and second preset distances L2 are provided between second inward-extension layers 120 positioned at the edges of the P-type silicon substrate 10 and the side surfaces of the P-type silicon substrate 10. Wherein, the second inward-extension layers 120 is a doped region formed in the P-type silicon substrate 10 on one side close to the second surface 12. The second inward-extension layers 120 may be formed by various doping methods (e.g., thermal diffusion, ion implantation, etc.), and the second inward-extension layers 120 may be doped with dopants having a conductivity type different from that of the P-type silicon substrate 10 during the doping process.

Therefore, when the N-type doped layers 40 are formed, the second inward-extension layers 120 are formed on the P-type silicon substrate 10, and the second inward-extension layers 120 at edge positions are configured to be spaced from the side surfaces of the P-type silicon substrate 10 by certain distances. Therefore, power leakage generated when the second inward-extension layers 120 extend to the edges of the P-type silicon substrate 10 to be in contact with the first inward-extension layers 110 can be avoided.

Specifically, the "second inward-extension layers 120 positioned at edges of the P-type silicon substrate 10 " mean second inward-extension layers 120 positioned at outermost edges of two sides, in an arrangement direction of the third regions 121 and the fourth regions 122, of the second surface 12 of the P-type silicon substrate 10. As shown in Fig. 7, the second inward-extension layers 120 positioned at the edges of the P-type silicon substrate 10 are a second leftmost inward-extension layer 120 and a second rightmost inward-extension layer 120 in Fig. 7. The side surfaces of the P-type silicon substrate 10 mean a left side surface and a right side surface in Fig. 7.

In such an example, the second preset distance may be 0.3 µm-50 µm. For example, the second preset distance may equal 0.3 µm, 0.4 µm, 0.5 µm, 0.6 µm, 0.7 µm, 0.8 µm, 0.9 µm, 1 µm, 2 µm, 3 µm, 4 µm, 5 µm, 6 µm, 7 µm, 8 µm, 9 µm, 10 µm, 15 µm, 20 µm, 25 µm, 30 µm, 40 µm, 45 µm, or 50 µm, or any value between 0.3 µm and 50 µm, which will not be specifically limited herein. In the example of the disclosure, the second preset distance may preferably be 1 µm-20 µm.

In some examples, a thickness of at least one of the second inward-extension layers 120 may be greater than a thickness of at least one of the first inward-extension layers 110. Therefore, the second inward-extension layers 120 have a larger thickness, so that the areas of the PN junctions can be further expanded to improve the efficiency of the solar cell 100.

In addition, in some examples, a width of at least one of the second inward-extension layers 120 may also be greater than a width of at least one of the first inward-extension layers 110. In this way, the areas of the PN junctions can be further expanded to improve the efficiency of the solar cell 100.

Moreover, in some examples, a doping concentration of at least one of the second inward-extension layers 120 may be greater than doping concentration of at least one of the first inward-extension layers 110. Therefore, by setting the doping concentration of at least one of the second inward-extension layers 120 higher, a passivation effect on regions making contact with the PN junctions can be improved.

With reference to Fig. 7, in some examples, the second preset distance L2 may preferably be greater than the first preset distance L1. Therefore, the second inward-extension layers 120 having a greater diffusion depth may be prevented from making contact with the first inward-extension layers 110 at the edges of the P-type silicon substrate 10.

In addition, in some examples, distances between N-type doped layers 40 positioned at the edges of the P-type silicon substrate 10 and the side surfaces of the P-type silicon substrate 10 are greater than those between P-type doped layers 20 positioned at the edges of the P-type silicon substrate 10 and the side surfaces of the P-type silicon substrate 10. Therefore, the second inward-extension layers 120 formed through the N-type doped layers 40 may be further prevented from making contact with the first inward-extension layers 110 formed through the P-type doped layers 20 at the edges of the P-type silicon substrate 10.

### Example 17

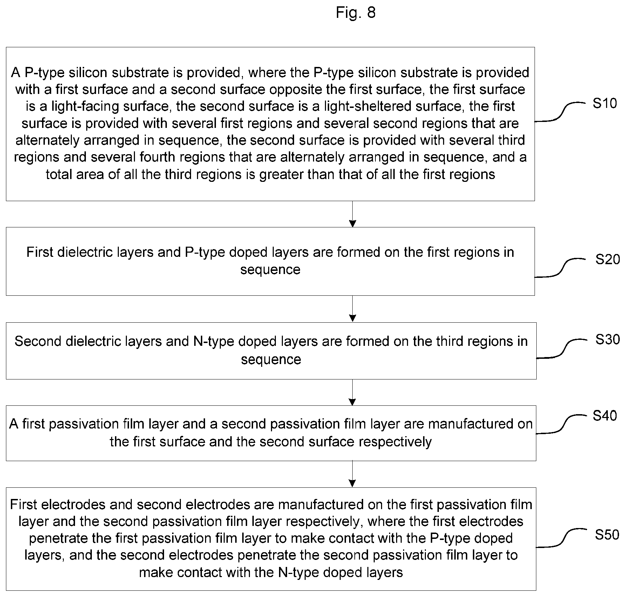

With reference to Fig. 8, a method for manufacturing for a solar cell 100 is provided in the example. The method includes:
S10: a P-type silicon substrate 10 is provided; where the P-type silicon substrate 10 is provided with a first surface 11 and a second surface 12 opposite the first surface 11, the first surface 11 is a light-facing surface, the second surface 12 is a light-sheltered surface, the first surface 11 is provided with several first regions 111 and several second regions 112 that are alternately arranged in sequence, the second surface 12 is provided with several third regions 121 and several fourth regions 122 that are alternately arranged in sequence, and a total area of all the third regions 121 is greater than that of all the first regions 111;
S20: first dielectric layers 30 and P-type doped layers 20 are formed on the first regions 111 in sequence;
S30: second dielectric layers 50 and N-type doped layers 40 are formed on the third regions 121 in sequence;
S40: a first passivation film layer 80 and a second passivation film layer 90 are manufactured on the first surface 11 and the second surface 12 respectively; and
S50: first electrodes 60 and second electrodes 70 are manufactured on the first passivation film layer 80 and the second passivation film layer 90 respectively, where the first electrodes 60 penetrate the first passivation film layer 80 to be in contact with the P-type doped layers 20, and the second electrodes 70 penetrate the second passivation film layer 90 to be in contact with the N-type doped layers 40.

Therefore, the P-type silicon substrate 10 is used as a base layer, the first surface 11 of the P-type silicon substrate 10 is not completely covered with the P-type doped layers 20, and the second surface 12 of the P-type silicon substrate is not completely covered with the N-type doped layers 40. In other words, the P-type doped layers are arranged only on the first region 111 for local passivation, and the first passivation film layer 80 is employed on the second regions 112 for direct passivation. Accordingly, passivation performance is desirable, and a passivation effect on the first surface 11 can be improved. In this way, the passivation effect can be improved while parasitic absorption of light rays by the P-type doped layers 20 and the N-type doped layers 40 can be effectively reduced, so that conversion efficiency can be improved. Moreover, on the P-type silicon substrate 10, the P-type doped layers 20 are locally arranged on the light-facing surface, so that the passivation effect can be improved while the parasitic absorption can be reduced. In addition, the N-type doped layers 40 are locally arranged on the light-sheltered surface, and the total area of all the third regions 121 is set to be greater than that of all the first regions 111, so that the reduction of efficiency caused by too small areas of PN junctions can be avoided while parasitic absorption on a rear surface can be reduced.

### Example 18

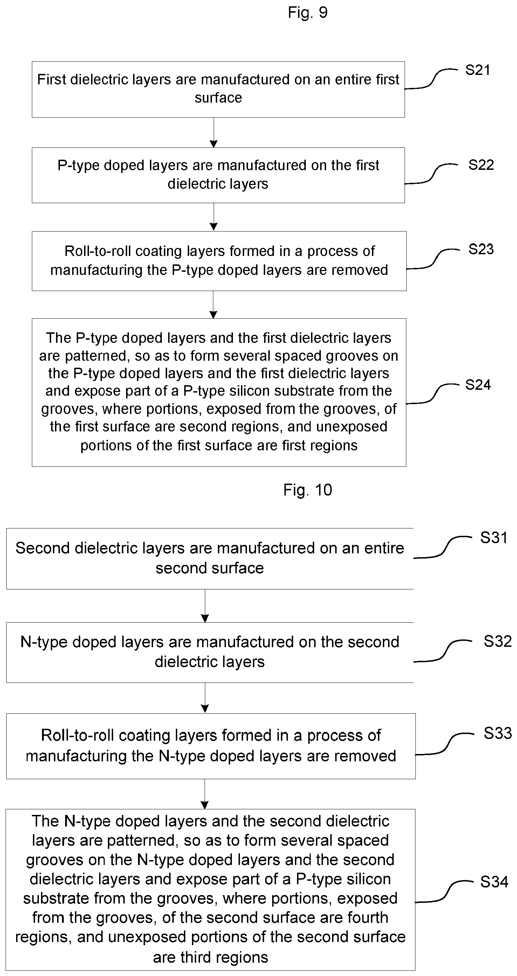

With reference to Fig. 9, in some examples, S20 may be implemented as follows:
S21: the first dielectric layers 30 are manufactured on an entire first surface 11;
S22: the P-type doped layers 20 are manufactured on the first dielectric layers 30;
S23: winding plating layers formed in a process of manufacturing the P-type doped layers 20 are removed; and
S24: the P-type doped layers 20 and the first dielectric layers 30 are patterned, so as to form several spaced grooves on the P-type doped layers 20 and the first dielectric layers 30 and expose part of the P-type silicon substrate 10 from the grooves, where portions, exposed from the grooves, of the first surface 11 are the second regions 112, and unexposed portions of the first surface are the first regions 111.

Specifically, in S21 and S22, the first dielectric layers 30 may be implemented through thermal oxidation, chemical liquid oxidation, chemical vapor deposition, or plasma treatment, etc., and the P-type doped layers 20 may be formed through physical vapor deposition or chemical vapor deposition, etc.

In S23, the winding plating layers formed in a deposition process may be removed through laser etching or wet etching. In S24, the P-type doped layers 20 and the first dielectric layers 30 may be patterned through one or a combination of at least two of acid etching, alkali etching, and laser etching. For example, in an instance, laser patterning may be performed first. Then, parts of the P-type doped layers 20 and parts of the first dielectric layers 30 may be removed through alkali etching, so as to form several grooves. Therefore, the first regions 111 having the P-type doped layers 20 and the second regions exposed 112 are formed on the P-type silicon substrate 10.

### Example 19

With reference to Fig. 10, in some examples, S30 may be implemented as follows:
S31: the second dielectric layers 50 are manufactured on an entire second surface 12;
S32: the N-type doped layers 40 are manufactured on the second dielectric layers 50;
S33: winding plating layers formed in a process of manufacturing the N-type doped layers 40 are removed; and
S34: the N-type doped layers 40 and the second dielectric layers 50 are patterned, so as to form several spaced grooves on the N-type doped layers 40 and the second dielectric layers 50 and expose part of the P-type silicon substrate 10 from the grooves, where portions, exposed from the grooves, of the second surface 12 are the fourth regions 122, and unexposed portions of the second surface are the third regions 121.

Specifically, in S31 and S32, the second dielectric layers 50 may be formed through thermal oxidation, chemical liquid oxidation, chemical vapor deposition, or plasma treatment, etc., and the N-type doped layers 40 may be formed through physical vapor deposition or chemical vapor deposition, etc., which will not be specifically limited herein.

In S33, the winding plating layers formed in a deposition process may also be removed through laser etching or wet etching. In S34, the N-type doped layers 50 and the second dielectric layers 50 may be patterned through one or a combination of at least two of acid etching, alkali etching, and laser etching. For example, in one example, laser patterning may be performed first. Then, parts of the N-type doped layers 40 and parts of the second dielectric layers 50 may be removed through alkali etching, so as to form several grooves. Therefore, the third region 121 having the N-type doped layers 40 and the fourth regions exposed 122 are formed on the P-type silicon substrate 10.

In the description, the descriptions with reference to the terms "some examples", "illustrative examples", "instances", "specific instances", or "some instances", etc., mean that a specific feature, structure, material, or characteristic described in connection with the examples or instances falls within at least one example or instance of the disclosure. In the description, the illustrative expressions of the above terms do not indicate the same examples or instances necessarily. Moreover, the specific feature, structure, material, or characteristic described can be combined in any one or more examples or instances in a suitable way.

## Claims

1. A solar cell, comprising:
a P-type silicon substrate(10), wherein the P-type silicon substrate(10) is provided with a first surface(11) and a second surface(12) opposite the first surface(11), the first surface(11) is a light-facing surface, the second surface(12) is a light-sheltered surface, the first surface(11) is provided with several first regions(111) and several second regions(112), the first regions (111) and the second regions (112) are alternately arranged in sequence, and the second surface(12) is provided with several third regions(121) and several fourth regions(122), the third regions(121) and fourth regions(122) are alternately arranged in sequence;
P-type doped layers(20), wherein the P-type doped layers (20) cover the first regions(111) only and do not cover the second regions(112) ;
first dielectric layers(30), wherein the first dielectric layers(30) are arranged between the P-type doped layers (20) and the first surface(11);
N-type doped layers(40), wherein the N-type doped layers(40) cover the third regions(121) only and do not cover the fourth regions(122), and a total area of all the third regions(121) is greater than a total area of all the first regions(111);
second dielectric layers(50), wherein the second dielectric layers(50) are arranged between the N-type doped layers(40) and the second surface(12); and
first electrodes(60) and second electrodes(70), wherein the first electrodes (60) are in contact with the P-type doped layers (20), and the second electrodes(70) are in contact with the N-type doped layers(40);
a first passivation film layer (80), wherein the first passivation film layer (80) covers the P-type doped layers (20) and the second regions (112) ;
a second passivation film layer (90), wherein the second passivation film layer (90) covers the N-type doped layers(40) and the fourth regions(122).

2. The solar cell according to claim 1, wherein areas of at least some of the third regions(121) are greater than areas of at least some of the first regions(111), or
an area of each third region(121) is greater than an area of each first region(111), or
the number of the first regions(111) is smaller than or equal to the number of the third regions(121).

3. The solar cell according to claim 1, wherein a ratio of a total area of the first regions(111) to an area of the first surface(11) is smaller than 8%, or
a ratio of a total area of the third regions(121) to an area of the second surface(12) is greater than or equal to 30% and smaller than 100%, or
an oxygen content in P-type silicon substrate(10) is smaller than or equal to 12.5 ppma.

4. The solar cell according to claim 1, wherein portions, corresponding to the first regions(111), of a surface of the P-type silicon substrate(10) are provided with non-textured structures; and/or
portions, corresponding to the first regions(111), of the surface of the P-type silicon substrate(10) are provided with pyramid base structures or micro-flock structures.

5. The solar cell according to claim 1, wherein portions, corresponding to the second regions(112), of a surface of the P-type silicon substrate(10) are provided with pyramid flocked structures, inverted-pyramid flocked structures, or chain pyramid flocked structures.

6. The solar cell according to claim 1, wherein portions, corresponding to the third regions(121), of a surface of the P-type silicon substrate(10) are provided with non-textured structures; or
portions, corresponding to the third regions(121), of the surface of the P-type silicon substrate(10) are provided with pyramid base structures or micro-flock structures.

7. The solar cell according to claim 1, wherein portions, corresponding to the fourth regions(122), of a surface of the P-type silicon substrate(10) are provided with non-textured structures; or
portions, corresponding to the fourth regions(122), of the surface of the P-type silicon substrate(10) are provided with pyramid base structures or micro-flock structures; or
portions, corresponding to the fourth regions(122), of the surface of the P-type silicon substrate(10) are provided with pyramid structures, inverted-pyramid structures, or chain pyramid flocked structures.

8. The solar cell according to claim 1, wherein a thickness of at least one of the N-type doped layers(40) is smaller than a thickness of at least one of the P-type doped layers (20), or
the P-type doped layers (20) and the N-type doped layers(40) comprise doped semi-insulating polysilicon layers, or
a width of at least one of the third regions(121) is greater than a width of at least one the first regions(111), or
a thickness of at least one of the first dielectric layers(30) is greater than a thickness of at least one of the second dielectric layers (50).

9. The solar cell according to claim 1, wherein the first dielectric layers(30) and the second dielectric layers(50) are porous dielectric layers, and a size of at least one pore in the first dielectric layers(30) is greater than a size of at least one pore in the second dielectric layers (50), or the first dielectric layers(30) and the second dielectric layers(50) are porous dielectric layers, and the number of pores per unit area in the first dielectric layers(30) is greater than the number of pores per unit area in the second dielectric layers(50).

10. The solar cell according to claim 1, wherein the second regions(112) and the fourth regions(122) are trench regions, or
trenches corresponding to the second regions(112) extend to portions below the P-type doped layers(20), and the P-type doped layers (20) comprise suspended portions suspended above the trenches, or
for at least one of the N-type doped layers(40), a width of a surface of the N-type doped layers(40) being in contact with the second dielectric layer (50) is greater than, a width of a surface of the N-type doped layer(40) provided with the second electrode (70), or
distances between N-type doped layers(40) positioned at edges of the P-type silicon substrate(10) and side surfaces of the P-type silicon substrate(10) are greater than distances between P-type doped layers(20) positioned at the edges of the P-type silicon substrate(10) and the side surfaces of the P-type silicon substrate(10).

11. The solar cell according to claim 1, wherein first inward-extension layers (110)are formed between the first dielectric layers(30) and the P-type silicon substrate(10), and first preset distances are provided between the first inward-extension layers(110) positioned at edges of the P-type silicon substrate(10) and side surfaces of the P-type silicon substrate(10).

12. The solar cell according to claim 11, wherein second inward-extension layers(120) are formed between the second dielectric layers(50) and the P-type silicon substrate(10), and second preset distances are provided between second inward-extension layers(120) positioned at the edges of the P-type silicon substrate(10) and the side surfaces of the P-type silicon substrate(10).

13. The solar cell according to claim 12, wherein a thickness of at least one of the second inward-extension layers(120) is greater than a thickness of at least one of the first inward-extension layers(110); and/or
a doping concentration of at least one of the second inward-extension layers(120) is greater than a doping concentration of at least one of the first inward-extension layer s(110); and/or
a width of at least one of the second inward-extension layers(120) is greater than a width of at least one of the first inward-extension layer s(110).

14. A method for manufacturing a solar cell, comprising:
providing a P-type silicon substrate(10), wherein the P-type silicon substrate(10) is provided with a first surface(11) and a second surface(12) opposite the first surface(11), the first surface(11) is a light-facing surface, the second surface(12) is a light-sheltered surface, the first surface(11) is provided with several first regions (111)and several second regions(112), the first regions(111) and the second regions(112) are alternately arranged in sequence, the second surface(12) is provided with several third regions(121) and several fourth regions(122), the third regions(121) and the fourth regions(122) are alternately arranged in sequence, and a total area of all the third regions(121) is greater than a total area of all the first regions(111);
forming first dielectric layers(30) and P-type doped layers(20) on the first regions(111) in sequence, wherein the P-type doped layers(20) cover the first regions (111) only and do not cover the second regions(112);
forming second dielectric layers(50) and N-type doped layers(40) on the third regions(121) in sequence, wherein the N-type doped layers(40) cover the third regions (121) only and do not cover the fourth regions(122);
manufacturing a first passivation film layer (80) and a second passivation film layer (90) on the first surface(11) and the second surface(12) respectively, wherein the first passivation film layer (80) covers the P-type doped layers (20) and the second regions (112) and the second passivation film layer (90) covers the N-type doped layers(40) and the fourth regions(122); and
manufacturing first electrodes(60) and second electrodes(70) on the first passivation film layer (80) and the second passivation film layer (90) respectively, wherein the first electrodes(60) penetrate the first passivation film layer (80) to be in contact with the P-type doped layers(20), and the second electrodes(70) penetrate the second passivation film layer (90) to be in contact with the N-type doped layers(40).

15. A cell assembly, comprising the solar cell(100) according to any one of claims 1-13.

## Patentansprüche

1. Solarzelle, umfassend:
ein P-Typ-Siliziumsubstrat (10), wobei das P-Typ-Siliziumsubstrat (10) mit einer ersten Oberfläche (11) und einer zweiten Oberfläche (12) gegenüber der ersten Oberfläche (11) bereitgestellt ist, die erste Oberfläche (11) eine lichtzugewandte Oberfläche ist, die zweite Oberfläche (12) eine lichtgeschützte Oberfläche ist, die erste Oberfläche (11) mit mehreren ersten Regionen (111) und mehreren zweiten Regionen (112) bereitgestellt ist, die ersten Regionen (111) und die zweiten Regionen (112) abwechselnd in Sequenz angeordnet sind, und die zweite Oberfläche (12) mit mehreren dritten Regionen (121) und mehreren vierten Regionen (122) bereitgestellt ist, wobei die dritten Regionen (121) und vierten Regionen (122) abwechselnd in Sequenz angeordnet sind;
P-dotierte Schichten (20), wobei die P-dotierten Schichten (20) nur die ersten Regionen (111) bedecken und die zweiten Regionen (112) nicht bedecken;
erste dielektrische Schichten (30), wobei die ersten dielektrischen Schichten (30) zwischen den P-dotierten Schichten (20) und der ersten Oberfläche (11) angeordnet sind;
N-dotierte Schichten (40), wobei die N-dotierten Schichten (40) nur die dritten Regionen (121) abdecken und die vierten Regionen (122) nicht abdecken, und ein Gesamtbereich aller dritten Regionen (121) größer ist als ein Gesamtbereich aller ersten Regionen (111);
zweite dielektrische Schichten (50), wobei die zweiten dielektrischen Schichten (50) zwischen den N-dotierten Schichten (40) und der zweiten Oberfläche (12) angeordnet sind; und
erste Elektroden (60) und zweite Elektroden (70), wobei die ersten Elektroden (60) in Kontakt mit den P-dotierten Schichten (20) stehen und die zweiten Elektroden (70) in Kontakt mit den N-dotierten Schichten (40) stehen;
eine erste Passivierungsfilmschicht (80), wobei die erste Passivierungsfilmschicht (80) die P-dotierten Schichten (20) und die zweiten Regionen (112) bedeckt;
eine zweite Passivierungsfilmschicht (90), wobei die zweite Passivierungsfilmschicht (90) die N-dotierten Schichten (40) und die vierten Regionen (122) bedeckt.

2. Solarzelle nach Anspruch 1, wobei die Bereiche von mindestens einigen der dritten Regionen (121) größer sind als die Bereiche von mindestens einigen der ersten Regionen (111), oder
ein Bereich jeder dritten Region (121) größer ist als ein Bereich jeder ersten Region (111), oder
die Anzahl der ersten Regionen (111) kleiner als oder gleich der Anzahl der dritten Regionen (121) ist.

3. Solarzelle nach Anspruch 1, wobei das Verhältnis des Gesamtbereichs der ersten Regionen (111) zum Bereich der ersten Oberfläche (11) kleiner als 8 % ist, oder
ein Verhältnis eines Gesamtbereichs der dritten Regionen (121) zu einem Bereich der zweiten Oberfläche (12) größer als oder gleich 30 % und kleiner als 100 % ist, oder
ein Sauerstoffgehalt im P-Typ-Siliziumsubstrat(10) kleiner als oder gleich 12,5 ppma ist.

4. Solarzelle nach Anspruch 1, wobei Abschnitte, die den ersten Regionen (111) entsprechen, einer Oberfläche des P-Typ Siliziumsubstrats (10) mit nichttexturierten Strukturen bereitgestellt sind; und/oder
Abschnitte, die den ersten Regionen (111) entsprechen, der Oberfläche des P-Typ-Siliziumsubstrats (10) mit pyramidenförmigen Basisstrukturen oder Mikroflockstrukturen bereitgestellt werden.

5. Solarzelle nach Anspruch 1, wobei den zweiten Regionen (112) entsprechende Abschnitte einer Oberfläche des P-Typ-Siliziumsubstrats (10) mit Pyramidenflockstrukturen, Umkehrpyramidenflockstrukturen oder Kettenpyramidenflockstrukturen bereitgestellt sind.

6. Solarzelle nach Anspruch 1, wobei Abschnitte, die den dritten Regionen (121) entsprechen, einer Oberfläche des P-Typ Siliziumsubstrats (10) mit nichttexturierten Strukturen bereitgestellt sind; oder
Abschnitte, die den dritten Regionen (121) entsprechen, der Oberfläche des P-Typ-Siliziumsubstrats (10) mit pyramidenförmigen Basisstrukturen oder Mikroflockstrukturen bereitgestellt werden.

7. Solarzelle nach Anspruch 1, wobei Abschnitte, die den vierten Regionen (122) entsprechen, einer Oberfläche des P-Typ Siliziumsubstrats (10) mit nichttexturierten Strukturen bereitgestellt sind; oder
Abschnitte, die den vierten Regionen (122) entsprechen, der Oberfläche des P-Typ-Siliziumsubstrats (10) mit pyramidenförmigen Basisstrukturen oder Mikroflockstrukturen bereitgestellt; oder
Abschnitte, die den vierten Regionen (122) der Oberfläche des P-Typ-Siliziumsubstrats (10) entsprechen, sind mit Pyramidenstrukturen, umgekehrten Pyramidenstrukturen oder Kettenpyramidenflockstrukturen bereitgestellt.

8. Solarzelle nach Anspruch 1, wobei die Dicke mindestens einer der N-dotierten Schichten (40) kleiner ist als die Dicke mindestens einer der P-dotierten Schichten (20), oder
die P-dotierten Schichten (20) und die N-dotierten Schichten (40) dotierte halbisolierende Polysiliziumschichten umfassen, oder
eine Breite von mindestens einer der dritten Regionen (121) größer als eine Breite von mindestens einer der ersten Regionen (111) ist, oder
eine Dicke von mindestens einer der ersten dielektrischen Schichten (30) größer als eine Dicke von mindestens einer der zweiten dielektrischen Schichten (50) ist.

9. Solarzelle nach Anspruch 1, wobei die ersten dielektrischen Schichten (30) und die zweiten dielektrischen Schichten (50) poröse dielektrische Schichten sind und eine Größe mindestens einer Pore in den ersten dielektrischen Schichten (30) größer ist als eine Größe mindestens einer Pore in den zweiten dielektrischen Schichten (50), oder die ersten dielektrischen Schichten (30) und die zweiten dielektrischen Schichten (50) sind poröse dielektrische Schichten, und die Anzahl der Poren pro Einheitsbereich in den ersten dielektrischen Schichten (30) ist größer als die Anzahl der Poren pro Einheitsbereich in den zweiten dielektrischen Schichten (50).

10. Solarzelle nach Anspruch 1, wobei die zweiten Regionen (112) und die vierten Regionen (122) Grabenregionen sind, oder
Gräben, die den zweiten Regionen (112) entsprechen, sich bis zu Abschnitten unterhalb der P-dotierten Schichten (20) erstrecken, und die P-dotierten Schichten (20) hängende Abschnitte umfassen, die über den Gräben hängen, oder
für mindestens eine der N-dotierten Schichten (40) eine Breite einer Oberfläche der N-dotierten Schichten (40), die in Kontakt mit der zweiten dielektrischen Schicht (50) steht, größer ist als eine Breite einer Oberfläche der N-dotierten Schicht (40), die mit der zweiten Elektrode (70) bereitgestellt wird, oder
Abstände zwischen N-dotierten Schichten (40), die an Kanten des P-Siliziumsubstrats (10) und Seitenoberflächen des P-Siliziumsubstrats (10) positioniert sind, größer sind als Abstände zwischen P-dotierten Schichten (20), die an den Kanten des P-Siliziumsubstrats (10) und den Seitenoberflächen des P-Siliziumsubstrats (10) positioniert sind.

11. Solarzelle nach Anspruch 1, wobei zwischen den ersten dielektrischen Schichten (30) und dem P-Typ-Siliziumsubstrat (10) erste nach innen gerichtete Schichten (110) gebildet werden und zwischen den ersten nach innen gerichteten Schichten (110), die an den Rändern des P-Typ-Siliziumsubstrats (10) und den Seitenoberflächen des P-Typ-Siliziumsubstrats (10) positioniert sind, erste voreingestellte Abstände bereitgestellt werden.

12. Solarzelle nach Anspruch 11, wobei zwischen den zweiten dielektrischen Schichten (50) und dem P-Typ-Siliziumsubstrat (10) zweite nach innen gerichtete Schichten (120) gebildet werden und zwischen den zweiten nach innen gerichteten Schichten (120), die an den Rändern des P-Typ-Siliziumsubstrats (10) positioniert sind, und den Seitenoberflächen des P-Typ-Siliziumsubstrats (10) zweite voreingestellte Abstände bereitgestellt werden.

13. Solarzelle nach Anspruch 12, wobei die Dicke mindestens einer der zweiten nach innen gerichteten Schichten (120) größer ist als die Dicke mindestens einer der ersten nach innen gerichteten Schichten (110); und/oder
eine Dotierungskonzentration von mindestens einer der zweiten nach innen gerichteten Schichten (120) größer ist als eine Dotierungskonzentration von mindestens einer der ersten nach innen gerichteten Schichten (110); und/oder
eine Breite von mindestens einer der zweiten nach innen gerichteten Schichten (120) größer ist als eine Breite von mindestens einer der ersten nach innen gerichteten Schichten (110).

14. Verfahren zur Herstellung einer Solarzelle, umfassend:
Bereitstellen eines P-Typ-Siliziumsubstrats (10), wobei das P-Typ-Siliziumsubstrat (10) mit einer ersten Oberfläche (11) und einer zweiten Oberfläche (12) gegenüber der ersten Oberfläche (11) bereitgestellt ist, die erste Oberfläche (11) eine lichtzugewandte Oberfläche ist, die zweite Oberfläche (12) eine lichtgeschützte Oberfläche ist, die erste Oberfläche (11) mit mehreren ersten Regionen (111) und mehreren zweiten Regionen (112) bereitgestellt ist, die ersten Regionen (111) und die zweiten Regionen (112) abwechselnd in Sequenz angeordnet sind, die zweite Oberfläche (12) mit mehreren dritten Regionen (121) und mehreren vierten Regionen (122) bereitgestellt ist, die dritten Regionen (121) und die vierten Regionen (122) abwechselnd in Sequenz angeordnet sind, und ein Gesamtbereich aller dritten Regionen (121) größer ist als ein Gesamtbereich aller ersten Regionen (111);
Bilden von ersten dielektrischen Schichten (30) und P-dotierten Schichten (20) auf den ersten Regionen (111) in Sequenz, wobei die P-dotierten Schichten (20) nur die ersten Regionen (111) abdecken und die zweiten Regionen (112) nicht abdecken;
Bilden von zweiten dielektrischen Schichten (50) und N-dotierten Schichten (40) auf den dritten Regionen (121) in Sequenz, wobei die N-dotierten Schichten (40) nur die dritten Regionen (121) abdecken und die vierten Regionen (122) nicht abdecken;
Herstellen einer ersten Passivierungsfilmschicht (80) und einer zweiten Passivierungsfilmschicht (90) auf der ersten Oberfläche (11) bzw. der zweiten Oberfläche (12), wobei die erste Passivierungsfilmschicht (80) die P-dotierten Schichten (20) und die zweiten Regionen (112) und die zweite Passivierungsfilmschicht (90) die N-dotierten Schichten (40) und die vierten Regionen (122) abdeckt; und
Herstellen von ersten Elektroden (60) und zweiten Elektroden (70) auf der ersten Passivierungsfilmschicht (80) bzw. der zweiten Passivierungsfilmschicht (90), wobei die ersten Elektroden (60) die erste Passivierungsfilmschicht (80) durchdringen, um in Kontakt mit den P-dotierten Schichten (20) zu stehen, und die zweiten Elektroden (70) die zweite Passivierungsfilmschicht (90) durchdringen, um in Kontakt mit den N-dotierten Schichten (40) zu stehen.

15. Zellenbaugruppe, umfassend die Solarzelle (100) nach einem der Ansprüche 1 bis 13.

## Revendications

1. Cellule solaire, comprenant :
un substrat de silicium de type P (10), dans laquelle le substrat de silicium de type P (10) est pourvu d'une première surface (11) et d'une seconde surface (12) opposée à la première surface (11), la première surface (11) est une surface exposée à la lumière, la seconde surface (12) est une surface à l'abri de la lumière, la première surface (11) est pourvue de plusieurs premières régions (111) et de plusieurs deuxièmes régions (112), les premières régions (111) et les deuxièmes régions (112) sont agencées alternativement en séquence, et la seconde surface (12) est pourvue de plusieurs troisièmes régions (121) et de plusieurs quatrièmes régions (122), les troisièmes régions (121) et les quatrièmes régions (122) sont agencées alternativement en séquence ;
des couches dopées de type P (20), dans laquelle les couches dopées de type P (20) recouvrent uniquement les premières régions (111) et ne recouvrent pas les deuxièmes régions (112) ;
des premières couches diélectriques (30), dans laquelle les premières couches diélectriques (30) sont agencées entre les couches dopées de type P (20) et la première surface (11) ;
des couches dopées de type N (40), dans laquelle les couches dopées de type N (40) recouvrent uniquement les troisièmes régions (121) et ne recouvrent pas les quatrièmes régions (122), et une aire totale de toutes les troisièmes régions (121) est supérieure à une aire totale de toutes les premières régions (111) ;
des secondes couches diélectriques (50), dans laquelle les secondes couches diélectriques (50) sont agencées entre les couches dopées de type N (40) et la seconde surface (12) ; et
des premières électrodes (60) et des secondes électrodes (70), dans laquelle les premières électrodes (60) sont en contact avec les couches dopées de type P (20), et les secondes électrodes (70) sont en contact avec les couches dopées de type N (40) ;
une première couche de film de passivation (80), dans laquelle la première couche de film de passivation (80) recouvre les couches dopées de type P (20) et les deuxièmes régions (112) ;
une seconde couche de film de passivation (90), dans laquelle la seconde couche de film de passivation (90) recouvre les couches dopées de type N (40) et les quatrièmes régions (122).

2. Cellule solaire selon la revendication 1, dans laquelle des aires d'au moins certaines des troisièmes régions (121) sont supérieures aux aires d'au moins certaines des premières régions (111), ou
une aire de chaque troisième région (121) est supérieure à une aire de chaque première région (111), ou
le nombre des premières régions (111) est inférieur ou égal au nombre des troisièmes régions (121).

3. Cellule solaire selon la revendication 1, dans laquelle un rapport entre une aire totale des premières régions (111) et une aire de la première surface (11) est inférieur à 8 %, ou
un rapport entre une aire totale des troisièmes régions (121) et une aire de la seconde surface (12) est supérieur ou égal à 30 % et inférieur à 100 %, ou
une teneur en oxygène dans le substrat de silicium de type P (10) est inférieure ou égale à 12,5 ppma.

4. Cellule solaire selon la revendication 1, dans laquelle des parties, correspondant aux premières régions (111), d'une surface du substrat de silicium de type P (10) sont pourvues de structures non texturées ; et/ou
des parties correspondant aux premières régions (111) de la surface du substrat de silicium de type P (10) sont pourvues de structures à base pyramidale ou de structures en micro-flocage.

5. Cellule solaire selon la revendication 1, dans laquelle des parties, correspondant aux deuxièmes régions (112), d'une surface du substrat de silicium de type P (10) sont pourvues de structures en flocage en pyramide, de structures en flocage en pyramide inversée, ou de structures en flocage en pyramide en chaîne.

6. Cellule solaire selon la revendication 1, dans laquelle des parties, correspondant aux troisièmes régions (121), d'une surface du substrat de silicium de type P (10) sont pourvues de structures non texturées ; ou
des parties correspondant aux troisièmes régions (121) de la surface du substrat de silicium de type P (10) sont pourvues de structures à base pyramidale ou de structures en micro-flocage.

7. Cellule solaire selon la revendication 1, dans laquelle des parties, correspondant aux quatrièmes régions (122), d'une surface du substrat de silicium de type P (10) sont pourvues de structures non texturées ; ou
des parties, correspondant aux quatrièmes régions (122), de la surface du substrat de silicium de type P (10) sont pourvues de structures à base pyramidale ou de structures en micro-flocage ; ou
des parties, correspondant aux quatrièmes régions (122), de la surface du substrat de silicium de type P (10) sont pourvues de structures en pyramide, de structures en pyramide inversée ou de structures en flocage en pyramide en chaîne.

8. Cellule solaire selon la revendication 1, dans laquelle une épaisseur d'au moins l'une des couches dopées de type N (40) est inférieure à une épaisseur d'au moins l'une des couches dopées de type P (20), ou
les couches dopées de type P (20) et les couches dopées de type N (40) comprennent des couches de polysilicium semi-isolantes dopées, ou
une largeur d'au moins l'une des troisièmes régions (121) est supérieure à une largeur d'au moins l'une des premières régions (111), ou
une épaisseur d'au moins l'une des premières couches diélectriques (30) est supérieure à une épaisseur d'au moins l'une des secondes couches diélectriques (50).

9. Cellule solaire selon la revendication 1, dans laquelle les premières couches diélectriques (30) et les secondes couches diélectriques (50) sont des couches diélectriques poreuses, et une taille d'au moins un pore dans les premières couches diélectriques (30) est supérieure à une taille d'au moins un pore dans les secondes couches diélectriques (50), ou les premières couches diélectriques (30) et les secondes couches diélectriques (50) sont des couches diélectriques poreuses, et le nombre de pores par unité de surface dans les premières couches diélectriques (30) est supérieur au nombre de pores par unité de surface dans les secondes couches diélectriques (50).

10. Cellule solaire selon la revendication 1, dans laquelle les deuxièmes régions (112) et les quatrièmes régions (122) sont des régions en tranchée, ou
des tranchées correspondant aux deuxièmes régions (112) s'étendent jusqu'à des parties situées sous les couches dopées de type P (20), et les couches dopées de type P (20) comprennent des parties suspendues au-dessus des tranchées, ou
pour au moins l'une des couches dopées de type N (40), une largeur d'une surface des couches dopées de type N (40) étant en contact avec la seconde couche diélectrique (50) est supérieure à une largeur d'une surface de la couche dopée de type N (40) pourvue de la seconde électrode (70), ou
les distances entre les couches dopées de type N (40) positionnées aux bords du substrat de silicium de type P (10) et des surfaces latérales du substrat de silicium de type P (10) sont supérieures aux distances entre les couches dopées de type P (20) positionnées aux bords du substrat de silicium de type P (10) et les surfaces latérales du substrat de silicium de type P (10).

11. Cellule solaire selon la revendication 1, dans laquelle des premières couches d'extension vers l'intérieur (110) sont formées entre les premières couches diélectriques (30) et le substrat de silicium de type P (10), et des premières distances prédéfinies sont prévues entre les premières couches d'extension vers l'intérieur (110) positionnées aux bords du substrat de silicium de type P (10) et les surfaces latérales du substrat de silicium de type P (10).

12. Cellule solaire selon la revendication 11, dans laquelle des secondes couches d'extension vers l'intérieur (120) sont formées entre les secondes couches diélectriques (50) et le substrat de silicium de type P (10), et des secondes distances prédéfinies sont prévues entre des secondes couches d'extension vers l'intérieur (120) positionnées aux bords du substrat de silicium de type P (10) et les surfaces latérales du substrat de silicium de type P (10).

13. Cellule solaire selon la revendication 12, dans laquelle une épaisseur d'au moins l'une des secondes couches d'extension vers l'intérieur (120) est supérieure à une épaisseur d'au moins l'une des premières couches d'extension vers l'intérieur (110) ; et/ou
une concentration de dopage d'au moins l'une des secondes couches d'extension vers l'intérieur (120) est supérieure à une concentration de dopage d'au moins l'une des premières couches d'extension vers l'intérieur (110) ; et/ou
une largeur d'au moins l'une des secondes couches d'extension vers l'intérieur (120) est supérieure à une largeur d'au moins l'une des premières couches d'extension vers l'intérieur (110).

14. Procédé de fabrication d'une cellule solaire, comprenant :
la fourniture d'un substrat de silicium de type P (10), dans lequel le substrat de silicium de type P (10) est pourvu d'une première surface (11) et d'une seconde surface (12) opposée à la première surface (11), la première surface (11) est une surface exposée à la lumière, la seconde surface (12) est une surface à l'abri de la lumière, la première surface (11) est pourvue de plusieurs premières régions (111) et de plusieurs deuxièmes régions (112), les premières régions (111) et les deuxièmes régions (112) sont agencées alternativement en séquence, la seconde surface (12) est pourvue de plusieurs troisièmes régions (121) et de plusieurs quatrièmes régions (122), les troisièmes régions (121) et les quatrièmes régions (122) sont agencées alternativement en séquence, et une aire totale de toutes les troisièmes régions (121) est supérieure à une aire totale de toutes les premières régions (111) ;
la formation de premières couches diélectriques (30) et de couches dopées de type P (20) sur les premières régions (111) en séquence, dans lequel les couches dopées de type P (20) recouvrent uniquement les premières régions (111) et ne recouvrent pas les deuxièmes régions (112) ;
la formation de secondes couches diélectriques (50) et de couches dopées de type N (40) sur les troisièmes régions (121) en séquence, dans lequel les couches dopées de type N (40) recouvrent uniquement les troisièmes régions (121) et ne recouvrent pas les quatrièmes régions (122) ;
la fabrication d'une première couche de film de passivation (80) et d'une seconde couche de film de passivation (90) sur la première surface (11) et la seconde surface (12) respectivement, dans lequel la première couche de film de passivation (80) recouvre les couches dopées de type P (20) et les deuxièmes régions (112) et la seconde couche de film de passivation (90) recouvre les couches dopées de type N (40) et les quatrièmes régions (122) ; et
la fabrication de premières électrodes (60) et de secondes électrodes (70) sur la première couche de film de passivation (80) et la seconde couche de film de passivation (90) respectivement, dans lequel les premières électrodes (60) pénètrent dans la première couche de film de passivation (80) pour être en contact avec les couches dopées de type P (20), et les secondes électrodes (70) pénètrent dans la seconde couche de film de passivation (90) pour être en contact avec les couches dopées de type N (40).

15. Ensemble cellule, comprenant la cellule solaire (100) selon l'une quelconque des revendications 1 à 13.
